# EUROPEAN PATENT APPLICATION

(11) **EP 0 574 179 A2**
(43) Date of publication of application: **15.12.1993**
(21) Application number: 93304297.0
(22) Date of filing: 03.06.1993
(51) Int. Cl.: H01L 21/90, G01B 7/34, H01L 21/66

(54) **Optimization of the planarization of a dielectric layer**

(30) Priority: 09.06.1992 US 895744
(71) Applicant: AT&T Corp., New York, NY 10013-2412 (US)
(72) Inventor: Chittipeddi, Sailesh, Whitehall, Pennsylvania 18052 (US); Cochran, William Thomas, New Tripoli, Pennsylvania 18066 (US)
(74) Representative: Johnston, Kenneth Graham

(57) **Abstract**

A process for tailoring and inspecting dielectric smoothing or planarization processes in semiconductor integrated circuit manufacturing is disclosed. A dielectric layer (e.g., 19) is formed and smoothed by a process which has at least one controllable parameter. A conductor (e.g., 23) is formed over the smoothed dielectric. The parameter is chosen so that the resistance ratio falls within a predetermined range.

## Description

### Technical Field

This invention relates to processes and methods for the formation of dielectric layers which are covered by conductive layers. More particularly, the invention finds applicability in the fabrication of integrated circuits in which dielectric layers are formed beneath conductive runners.

### Background of the Invention

Various modern technologies employ dielectric layers which are covered by conductors. For example, electronic integrated circuits frequently utilize dielectric layers (which may be formed from various forms of silicon dioxide) which are covered by and which support conductive runners. The runners, often made from aluminum, silicide, or polysilicon, interconnect various devices within the integrated circuit.

Typically, it is often considered desirable to planarize or at least smooth the dielectric layer before overlying conductive runners are formed. Should conductive runners be formed upon a dielectric layer with a substantially non-planar upper surface, breaks may occur in the conductor, thus adversely affecting circuit performance.

Various techniques are used to planarize or smooth dielectric surfaces. Mechanical polishing is occasionally used to flatten dielectric surfaces. Various etchback techniques, some employing resist, are used by others to smooth dielectric surfaces. Another approach is to heat the dielectric, thus causing it to flow, thereby smoothing its upper surface. (The terms *planarization* and *smoothing* are used interchangeably herein.)

Typical silicon dioxide-based dielectrics often utilize dopants such as boron and phosphorus to improve flowability. A variety of inter-related parameters such as concentration of each dopant, and flow time and temperature, contribute to the smoothness of the dielectric after flow.

Heretofore, the most popular method for evaluating the adequacy of smoothing or planarization has been the use of scanning electron micrograph (SEM). Unfortunately, evaluation of SEM photographs is somewhat subjective and imprecise. In addition, SEM evaluation is not easily compatible with statistical process control methodologies due to the time consuming nature of data collection. Those concerned with the progress of the integrated circuit industry have searched for better and less subjective methods of evaluating the adequacy of planarization and smoothing techniques so that overlying conductors are not degraded. There is interest in the development of a method for evaluating the effectiveness of planarization and smoothing methods so that new planarization and smoothing processes may be developed and, also, so that processes which are being utilized in a production environment may be continuously quality-checked.

### Summary of the Invention

Illustratively, many of the above-mentioned goals may be accomplished by forming a dielectric layer and smoothing it by a process which has at least one controllable parameter. Then a conductor is formed upon the smoothed dielectric. The parameter is chosen so that the resistance ratio of the conductor falls within a predetermined range. (The resistance ratio, known to those skilled in the art, is defined as the ratio of the resistance of a conductive stripe over the smoothed dielectric to the resistance of a conductive stripe of the same length and width over a completely flat dielectric.)

By example, but not limitation, the dielectric may be doped with dopants in a certain concentration. The concentration (i.e., one possible smoothing parameter) is chosen so that the resistance ratio of the conductor formed over the smoothed dielectric is close to 1 for all desired spacings between the runners.

Another embodiment includes the use of resistance ratio measurements to provide quality control checks on manufactured semiconductor products. For example, the resistance ratio of conductors on wafers undergoing production processing may be compared with a predetermined numerical range. If the ratio is within the range, the process is presumed to be working satisfactorily. Should the value be outside the range, the process may be deemed to have deviated in some way from its original design and corrective action may be undertaken.

### Brief Description of the Drawings

FIGS. 1-4 are schematic cross-sectional views useful in understanding various illustrative embodiments of the invention; and
FIGS. 5-8 are graphs useful in understanding various embodiments of the invention.

### Detailed Description

Reference numeral 11 denotes a substrate upon which raised topological features 15 and 13 are formed. Substrate 11 may be silicon, polysilicon, epitaxial or doped silicon. Alternatively, substrate 11 may be a form of doped or undoped silicon dioxide, or a nitride. Other substrate materials may also be used.

Topological features 15 and 13 may, for example, be conductive runners made from aluminum, polysilicon, silicide, or other conductive materials. However, topological features 15 and 13 may representative a variety of other integrated circuit elements such as gates or even field oxides.

Layer 17 is a layer (or multiple layers) which may optionally be deposited or formed over features 13 and 15. Layer 17 may be a nitride or a silicon dioxide (which may be formed from a variety of precursor gases such as TEOS).

Formed on top of layer(s) 17 or on top of features 15 and 13 if layer(s) 17 is(are) absent, is dielectric layer 19. It is desired to planarize or smooth layer 19 so that runners which are subsequently formed over layer 19 do not exhibit cracks or voiding.

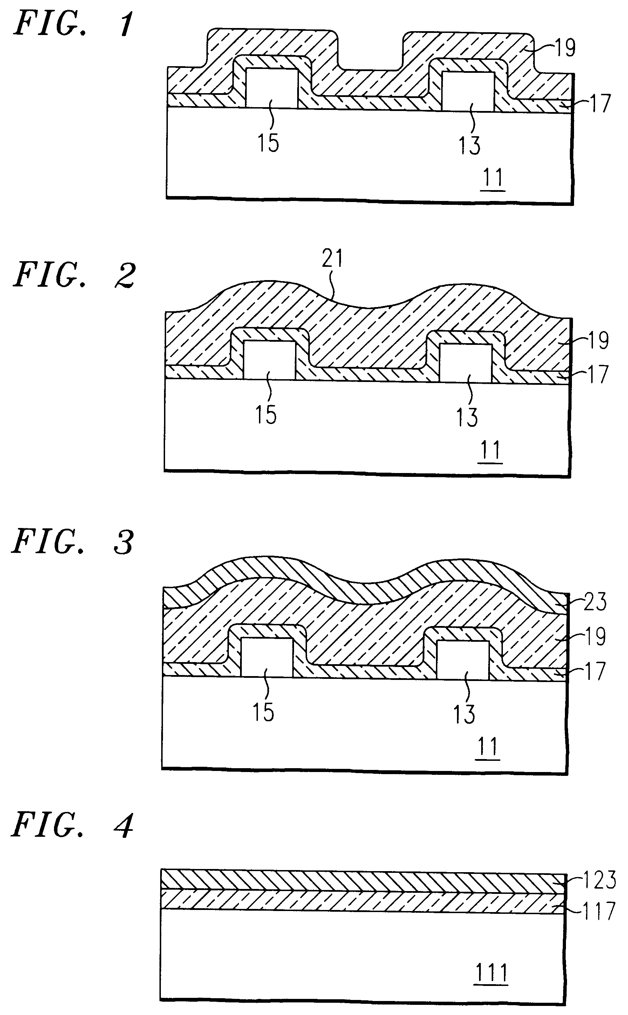

FIG. 2 depicts the structure of FIG. 1 after layer 19 has been planarized (either locally or globally) or smoothed. A variety of techniques may be employed to planarize or smooth layer 19. For example, mechanical polishing with or without chemical assistance may be employed. Alternatively, if layer 19 contains dopants, the structure may be heated causing layer 19 to flow, thereby creating a smoothed upper surface 21 of layer 19.

Turning to FIG. 3, conductive layer 23 is formed upon smoothed upper surface 21 of layer 19. Those skilled in the art have realized that if upper surface 21 of layer 19 is not sufficiently smooth, layer 23 may not adequately cover layer 19, or cracks or voids may subsequently appear in layer 23. Both poor coverage and cracks or voids, of course, impede the usefulness of layer 23 as an upper level conductor in an integrated circuit. Consequently, it is desirable that the planarization or smoothing process employed for layer 19 be tailored to have a minimal adverse effect upon the integrity of conductive layer 23.

In other words, it is desirable that whatever parameters govern the planarization or smoothing process employed for layer 19 (e.g., dopant concentration, reflow time, chemical slurry composition, mechanical polishing time, duration of plasma etchback, power, pressure, etc.) be tailored so that the resulting conductivity of layer 23 is as close as possible to the conductivity of similar material deposited upon a truly planar surface. Dielectric thickness and also the spacing between features 13 and 15 may also be considered smoothing parameters.

For example, FIG. 4 depicts conductive layer 123 deposited upon (optional) dielectric 117 overlying substrate 111.

The planarization or smoothing process for layer 19 may be tailored by measuring the resistance ratio of layer 23 as a function of one or more selected parameters which characterize the planarization or smoothing process for layer 19. The resistance ratio is the ratio of the resistance of layer 23 (which may be a conductive runner) to the resistance of a layer of similar material 123 formed over flat or planar surface (with corresponding runner dimensions, material composition, etc., maintained constant). Resistance ratios may be measured by those of ordinary skill in the art.

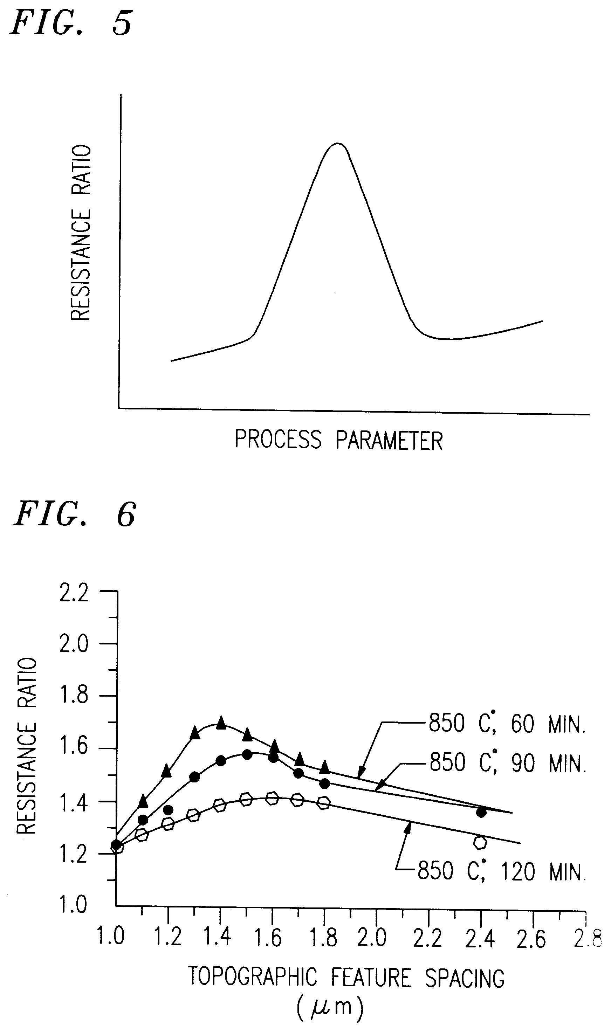

In general terms, when the resistance ratio is plotted as a function of the underlying smoothing process parameter, a graph such as that of FIG. 5 obtains. (As will be appreciated from the following paragraphs, the exact shape of the curve of FIG. 5 is not critical.) Nevertheless, examination of the graph of FIG. 5 enables one to adjust the process parameter(s) in a way to reduce the resistance ratio of a layer or runner 23 to a predetermined desired value (which may be a minimal value). A resistance ratio of 1 is considered ideal since it implies that the resistance of a runner formed over topography is equal to the resistance of a runner formed over a flat or planar substrate.

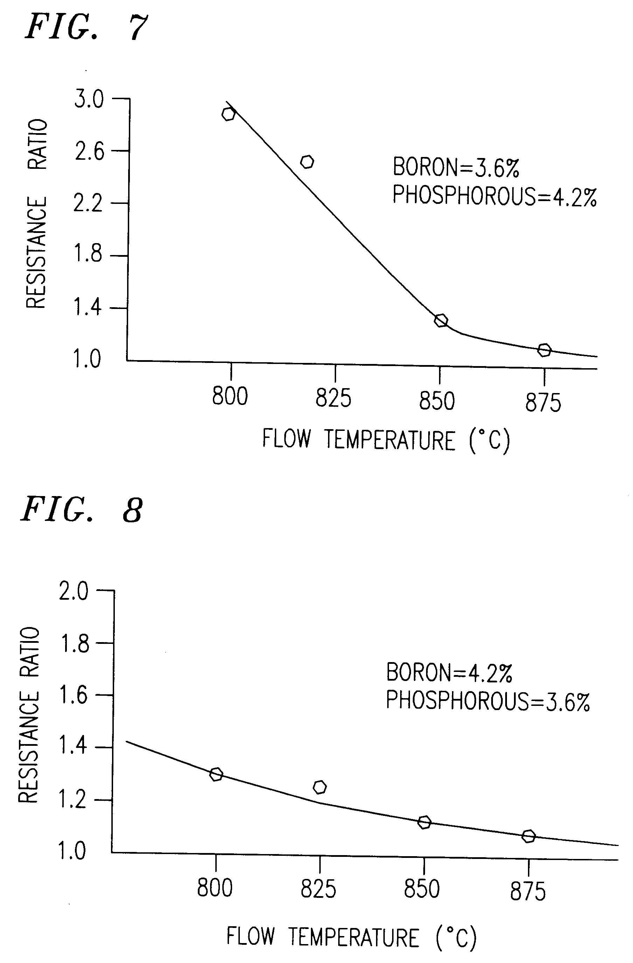

For example, FIG. 7 depicts the resistance ratio of conductive runners formed over doped silicon dioxide which has been flowed at various temperatures. The silicon dioxide has been doped with boron (in an amount equal to 3.6 percent) and phosphorus in an amount equal to 4.2 percent by weight. The topography beneath the doped silicon dioxide was the same for each data point. Examination of the graph of FIG. 7 shows that the most desirable resistance ratio is obtained for a flow temperature of 875°. Thus, a designer, confronted with an established underlying topography and, wishing to maintain dopant concentrations at the levels specified above, may choose, with the aid of FIG. 7, the most desirable flow temperature.

Similarly, FIG. 8 depicts the resistance ratio of conductive runners over flowed, doped silicon dioxide. However, the silicon dioxide of FIG. 8 has a different boron and phosphorus concentration (boron equals 4.2 percent by weight; phosphorus equals 3.6 percent by weight.). Again, the designer utilizing FIG. 8, may select that flow temperature (in this case, perhaps 875°) which provides the lowest resistance ratio for the conductive runners.

Taking FIGS. 8 and 7 together, the designer may compare both flow temperature and the composition and may conclude that the dopant concentrations in FIG. 8 provide a resistance ratio below 1.2 which may be more desirable than a resistance ratio provided in FIG. 7.

Thus, systematic evaluation of the resistance ratio has a function of underlying dielectric smoothing parameters (including different spacing of underlying topographic features 13 and 15), permits precise tailoring of the smoothing process so that the resistance ratios may be made most desirable. Usually, it is desirable that the resistance ratio by minimized, i.e., brought as close to 1 as possible. However, in order to accommodate the practicalities of integrated circuit manufacturing, the designer may elect to compromise between various parameters and may choose a set of smoothing parameters which are not necessarily minimal. Nevertheless, the inventive technique provides the designer with great insight into the effects of the silicon dioxide smoothing process upon overlying runner resistance ratios.

FIG. 6 is a graph depicting resistance ratio as a function of underlying topography spacing. The curves of FIG. 6 depict the resistance ratio for silicon dioxide (of fixed dopants concentration) flowed at different times. The graph enables the designer to clearly understand, for example, that for underlying topographic feature spacing of approximately 1.4 microns a flow time of 60 minutes produces (compared to other available flow times) resistance ratios which may be undesirably high. However, it may be noted that, for larger topographic feature spacing (i.e., 2.4 microns) the resistance ratios for glass flowed at 60 minutes and 90 minutes become almost indistinguishable. Thus, a designer, knowing the topographic feature spacing of his circuit, may, perhaps elect to save valuable process time (i.e., 30 minutes) and may choose to flow the silicon dioxide dielectric for only 60 minutes (although 120 minutes would still offer a little better resistance ratio).

Furthermore, in a general sense, one may consider the resistance ratio of an overlying conductor to be a function of multiple controllable variables which govern smoothing or formation of the underlying dielectric. A series of experiments (perhaps utilizing the Taguchi technique) may be performed to determine the functional relationship. Then the designer may choose a desired set of process parameters (which may, though not necessarily, produce a minimal resistance ratio) with knowledge of how variation of each parameter from the chosen set will affect the resistance ratio.

The inventive process may find a number of applications. The paragraphs above have described how a designer may tailor a dielectric smoothing process to produce whatever resistance ratio he desires in the overlying conductive runners. However, after an integrated circuit manufacturing process has been introduced into a production facility, it is desirable to maintain continuous quality control checks on the outcoming product. The inventive concepts may be utilized to perform such quality control checks.

For example, a small portion of the wafer may be dedicated to the fabrication of the test structure somewhat analogous to FIG. 3. The test structure will have a typical underlying topography, 15 and 13, with a flowed overlying dielectric 21 and conductive runner 23. The resistance ratio of conductive runner 23 may be measured during the manufacturing process and compared with the resistance ratio specified by the circuit designer. Should the actual manufactured resistance ratio not meet the specified resistance ratio, it provides a good indication that there is a problem in the manufacturing process. The problem may likely be found in either the formation of runner 23 or the formation and subsequent smoothing of dielectric 21.

Statistical process control of spatially dependent parameters in the dielectric smoothing process may be easily evaluated. For example, several test structures may be formed upon a wafer and each structure evaluated as a function of, for example, distance from the center of the wafer.

## Claims

1. A method of semiconductor integrated circuit fabrication comprising:
forming a dielectric layer (e.g., 19) having a thickness;
smoothing said layer (e.g., 19) by a process which has at least one controllable parameter;
forming a conductor (e.g., 23) upon said smoothed layer;
CHARACTERIZED IN THAT said parameter is chosen so that the resistance ratio of said conductor (e.g., 23) falls within a predetermined range.

2. The method of claim 1 in which said dielectric (e.g., 19) includes at least one dopant and is smoothed by a process which includes heating for a period of time at a temperature and in which said parameter is chosen from:
dopant concentration;
period of time;
temperature; and
dielectric thickness.

3. The method of claim 1 in which said method of smoothing includes an etchback procedure which is performed for a period of time at a power and pressure, utilizing one or more gas compositions and, optionally, utilizing a resist composition and said parameter is chosen from:
period of time;
power;
pressure;
resist composition;
gas composition; and
dielectric thickness.

4. The method of claim 1 in which said method of smoothing includes a mechanical polishing procedure, performed for a period of time and utilizing a slurry composition, and said parameter is chosen from:
period of time;
slurry composition; and
dielectric thickness.

5. A method of semiconductor integrated circuit manufacturing comprising:
performing a quality check on a wafer by
forming a first dielectric layer (e.g., 19) overlying said first wafer;
smoothing said first dielectric layer (e.g., 19) by a first process which has at least one controllable parameter; forming a first conductor (e.g., 23) upon said smoothed first dielectric; measuring the resistance ratio of said conductor (e.g., 23) and comparing said measured resistance ratio to a predetermined value;
forming a second dielectric layer (e.g., 19) overlying a second wafer;
smoothing said second dielectric layer (e.g., 19) by a second process which has said controllable parameter:
forming a second conductor (e.g., 23) upon said second smoothed dielectric;
measuring the resistance ratio of said second conductor (e.g., 23); and
CHARACTERIZED BY adjusting said controllable parameter so that said resistance ratio of said second conductor is closer to said predetermined value than said resistance ratio of said first conductor.

6. The method of claim 5 in which said dielectric includes at least one dopant and is smoothed by a process which includes heating for a period of time at a temperature and in which said parameter is chosen from:
dopant concentration;
period of time and;
temperature; and
dielectric thickness.

7. The method of claim 5 in which said method of smoothing includes a mechanical polishing procedure, performed for a period of time, and utilizing a slurry composition, and said parameter is chosen from:
period of time and;
slurry composition; and
dielectric thickness.

8. The method of claim 5 in which said method of smoothing includes an etchback procedure which is performed for a period of time at a power and pressure, utilizing one or more gas compositions, and, optionally, utilizing a resist composition and said parameter is chosen from:
period of time;
power;
pressure;
resist composition;
gas composition; and
dielectric thickness.

9. A method of semiconductor integrated circuit processing comprising:
forming a plurality of test structures upon a wafer, each test structure having a conductive layer (e.g., 23) over a smoothed dielectric (e.g., 19);
measuring the resistance ratio of each conductor (e.g., 23) of each test structure and comparing said resistance ratio to a predetermined numerical range;
adjusting said process if any of said resistance ratios is outside said range to cause said resistance ratio to fall within said range.
